(19) Europäisches Patentamt
European Patent Office
Office européen des brevets

(11) EP 1 528 125 B1

(12) EUROPEAN PATENT SPECIFICATION

(45) Date of publication and mention of the grant of the patent:
**24.12.2008 Bulletin 2008/52**

(51) Int Cl.:
*C23C 30/00* (2006.01) *C23C 16/40* (2006.01)
*C23C 28/00* (2006.01) *C22C 29/08* (2006.01)

(21) Application number: **04445110.2**

(22) Date of filing: **15.10.2004**

# (54) Coated cutting insert for rough turning

Beschichteter Schneideinsatz zum Schruppen

Plaquette revêtue pour dégrossissage

(84) Designated Contracting States:
**AT BE BG CH CY CZ DE DK EE ES FI FR GB GR HU IE IT LI LU MC NL PL PT RO SE SI SK TR**

(30) Priority: **27.10.2003 SE 0302842**

(43) Date of publication of application:
**04.05.2005 Bulletin 2005/18**

(73) Proprietor: **Seco Tools AB**
**737 82 Fagersta (SE)**

(72) Inventors:
- **Ruppi, Sakari**
  **737 44 Fagersta (SE)**
- **Dahlund, Silvia**
  **777 60 Söderbärke (SE)**
- **Zackrisson, Jenni**
  **737 47 Fagersta (SE)**

(74) Representative: **Taquist, Henrik Lennart Emanuel et al**
**Sandvik AB,**
**Intellectual Property**
**811 81 Sandviken (SE)**

(56) References cited:
**EP-A- 1 026 271**
**EP-A- 1 247 789**
**EP-A- 1 288 335**
**EP-B- 0 630 744**
**US-A- 5 654 035**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### Background of the Invention

The present invention relates to a coated cemented carbide cutting tool insert particularly useful for toughness demanding machining such as medium and rough turning of steels and also for turning of stainless steels. The invention preferably relates to coated inserts in which the substrate has been provided with a tough surface region in such a way that wear resistance and edge strength are obtained in the same grade.

Today, coated cemented carbide inserts with binder phase enriched surface zone are commonly used for turning of steel and stainless steel materials. The binder phase enriched surface zone widens the application towards tougher cutting operations.

It has been known for some time how to produce binder phase enriched surface zones on cemented carbides containing WC, binder phase and cubic carbide phase, e.g. through Tobioka et al.(US 4,277,283), Nemeth et al.(US 4,610,931) and Yohe (US 4,548,786).

EP-A-1 026 271 relates to a coated cemented carbide with binder phase highly alloyed with W. The insert has a binder phase enriched surface zone of a thickness <20 μm and along a line in the direction from the edge to the centre of the insert the binder phase content increases essentially monotonously until it reaches the bulk composition. The insert is coated with 3-12 μm columnar Ti(C,N)-layer followed by a 2-12 μm thick $Al_2O_3$-layer.

EP-A-1 348 779 relates to a coated cemented carbide insert with a binder phase enriched surface zone with a thickness of >20 μm and a Co-content of 4-7 wt-%. The insert is coated with a 3-15 μm thick Ti(C,N) layer followed by 3-15 μm $\alpha$-$Al_2O_3$ and an uppermost 1-10 μm thick layer of a carbide, carbonitride or carboxynitride.

US 7,163,735 discloses a method to produce $\alpha$-$Al_2O_3$ coatings with higher wear resistance and toughness than the prior art. The $\alpha$-$Al_2O_3$ coating is formed on a bonding layer of (Ti,Al)(C,O,N) with increasing aluminium content towards the outer surface. The $\alpha$-$Al_2O_3$ coating has a thickness ranging from 1 to 20 μm and is composed of columnar grains. The length/width ratio of the alumina grains is from 2 to 12. The coating is characterised by a strong (012) growth texture, measured using XRD, and by the almost total absence of (104), (110), (113) and (116) diffraction reflections.

EP 1288335 discloses a cutting tool having a hard coating layer including: a Ti compound layer, as a lower layer, having an average thickness of 0.5 to 20 μm and made of at least one layer chosen from a carbide of Ti layer, a nitride of Ti layer, a carbonitride of Ti layer, a carboxide of Ti layer and a carbonitroxide of Ti layer; an aluminum oxide layer, as an intermediate layer, with an average thickness of 1 to 25 μm and a heat transformed $\alpha$-type crystal structure derived from a vapor deposited $\kappa$- or $\theta$-type aluminum oxide layer, and an $\alpha$-aluminum oxide layer, as an upper layer having an average thickness of 0.3 to 10 μm.

EP 630744 discloses a cutting material consisting of a basic cemented carbide body and a multilayer coating. The basic body and coating are specifically matched to one another, as a result of which the cutting material is exceptionally well suited to the cutting of both steel and cast iron.

US 5,654,035 discloses a method of coating a body with refractory single- or multi-layers, wherein specific layers are characterized by a controlled microstructure and phase composition with crystal planes preferably grown in a preferential direction with respect to the surface of the coated body. The coating comprises one or more refractory layers of which at least one layer is a dense, fine-grained layer of $\alpha$-$Al_2O_3$ preferably textured in the (012) direction.

The coatings for cutting tools designed for toughness demanding applications are usually composed of layers of Ti(C,N) and kappa alumina. It has been thought that the kappa phase shows better toughness properties than the alpha phase. Consequently, alpha alumina has so far only been applied for applications where wear resistance is the main concern, i.e. for grades with relatively low Co-contents.

### Summary of the Present Invention

It has surprisingly been found that a relatively thick alpha alumina with strong texture in combination with a substrate of relatively high cobalt content shows enhanced edge strength and toughness in medium and rough turning of steels and turning of stainless steels.

### Brief Description of the Drawings

Fig. 1 shows the structure of the tool insert according to the invention in approximately 1200X magnification.
Figs. 2a and 2b show the wear of the cutting edges after the machining test in Example 4.
Fig. 3 shows the number of undamaged cutting edges vs. feed in the cutting test in Example 5.

Detailed description of the Present invention

According to the present invention a coated cutting tool insert is provided consisting of a cemented carbide body with a composition of 8.5-9.5 wt-% Co. 6.5-9.5 wt-%, cubic carbides of the metals Ti, Nb and Ta, and balance WC. The ratio between the weight concentrations of Ta and Nb is within 1.0-3.0. The ratio between the weight concentrations of Ti and Nb is within 0.5-1.5.

The cobalt binder phase is highly alloyed with tungsten. The concentration of W in the binder phase may be expressed as the S-value = $\sigma$ / 16.1, where $\sigma$ is the measured magnetic moment of the binder phase in $\mu Tm^3kg^{-1}$. The S-value depends on the content of tungsten in the binder phase and increases with a decreasing tungsten content. Thus, for pure cobalt, or a binder that is saturated with carbon, S=1 and for a binder phase that contains W in an amount that corresponds to the borderline to formation of $\eta$-phase, S=0.78.

It has now been found according to the present invention that improved cutting performance is achieved if the cemented carbide body has an S-value within the range 0.79-0.89.

Furthermore, the mean intercept length of the tungsten carbide phase measured on a ground and polished representative cross section is in the range 0.9-1.3 $\mu$m. The intercept length is measured by means of image analysis on pictures with a magnification of 10000$\times$ and calculated as the average mean value of approximately 1000 intercept lengths.

The cemented carbide is provided with a 20-40 $\mu$m thick, essentially cubic carbide phase free and binder phase enriched surface zone with an average binder phase content in the range 1.2-2.5 times the nominal binder phase content.

The method of making cutting tool inserts according to the invention providing a cemented carbide substrate consisting of a binder phase of Co, WC and a cubic carbonitride phase with a binder phase enriched surface zone essentially free of cubic phase and a coating. A powder mixture containing 8,5-9,5wt%, of binder phase consisting of Co, and preferably 6.5-9.5 wt-%, cubic carbides of the metals Ti, Nb and Ta, and balance WC. The ratio between the weight concentrations of Ta and Nb is within 1.0-3.0, preferably 1.5-2.5. The ratio between the weight concentrations of Ti and Nb is within 0.5-1.5, preferably 0.8-1.2. Well-controlled amounts of nitrogen are added through the powder e.g. as nitrides. The optimum amount of nitrogen to be added depends on the composition of the cemented carbide and in particular on the amount of cubic phases and is higher than 1.7%, preferably 1.8-5.0%, most preferably 3.0-4.0 wt-%, of the weight of the elements from groups IVb and Vb of the periodic table. The exact conditions depend to a certain extent on the design of the sintering equipment being used. It is within the purview of the skilled artisan to determine and to modify the nitrogen addition and the sintering process in accordance with the present specification in order to obtain the desired result.

The raw materials are mixed with pressing agent and possibly W such that the desired S-value is obtained and the mixture is milled and spray dried to obtain a powder material with the desired properties. Next, the powder material is compacted and sintered. Sintering is performed at a temperature of 1300-1500°C, in a controlled atmosphere of about 50 mbar followed by cooling. After conventional post sintering treatments including edge rounding a hard, wear resistant coating according to the below is applied by CVD- or MT-CVD-technique.

The coating comprises a first layer adjacent the body of CVD Ti(C,N), CVD TiN, CVD TiC, MTCVD Ti(C,N), MTCVD Zr(C,N), MTCVD Ti(B,C,N), CVD HfN or combinations thereof preferably of MTCVD Ti(C,N) having a thickness of from 1 to 10 $\mu$m, preferably from 3 to 8 $\mu$m, most preferably about 6 $\mu$m and $\alpha$-$Al_2O_3$ layer adjacent said first layer having a thickness of from about 2 to 12 $\mu$m, preferably from 3 to 10 $\mu$m, most preferably about 5 $\mu$m. Preferably there is an intermediate layer of TiN between the substrate as well as in the said first layer both with a thickness of <3 $\mu$m, preferably about 0.5 $\mu$m.

The $\alpha$-$Al_2O_3$ layer is the uppermost layer.

The total coating thickness shall be 7-15 $\mu$m, preferably 8-13 $\mu$m.

The $\alpha$-$Al_2O_3$ layer is composed of columnar grains with a strong (012) texture. The columnar grains have a length/width ratio of from 2 to 10, preferably 4 to 8 with a width of 0.5-3.0 $\mu$m.

The texture coefficients (TC) for the $\alpha$-$Al_2O_3$ layer is determined as follows:

$$TC(hkl) = \frac{I(hkl)}{I_O(hkl)} \left\{ \frac{1}{n} \sum \frac{I(hkl)}{I_O(hkl)} \right\}^{-1}$$

where

I(hkl) = intensity of the (hkl) reflection

$I_O$(hkl) = standard intensity according to JCPDS card no 46-1212

n = number of reflections used in the calculation

(hkl) reflections used are: (012), (104), (110), (113), (024), (116).

The texture of the alumina layer is defined as follows:

TC(012) 2.8-3.5 and the related TC(024) > 0.6 x TC(012) and simultaneously TC(104), TC(110), TC(113), TC(116) < 0.3.

It is noted that the intensities of the planes 012 and 024 are related.

$\alpha$-$Al_2O_3$ is deposited on a Ti(C,N) coating which is obtained preferably by MTCVD. Several steps are needed to control nucleation as described in US. 7 163 735. First, on the Ti(C,N) layer a modified bonding layer described in US 5,137,774 (referred to as kappa-bonding in this patent) is deposited characterised by the presence of an Al concentration gradient. The controlled oxidation treatment is performed in this case using a $CO_2/H_2/N_2$ gas mixture resulting in a lower O-potential than in US. 7 163 735 enhancing the (012) texture further. The oxidation step is short and may be followed by a short treatment with a $AlCl_3/H_2$ mixture, again followed by a short oxidisation step. This kind of pulsating (Al-treatments/oxidisation) treatments will create favourable nucleation sites for $\alpha$-$Al_2O_3$ and a strong (012) texture. The growth of the alumina layer onto the surface modified bonding layer is started by sequencing the reactant gases in the following order: CO, $AlCl_3$, $CO_2$. The temperature shall preferably be about 1000 °C.

Examples

Example 1 Invention

A cemented carbide substrate in accordance with the invention with the composition 9.0 wt-% Co, 3.6 wt-% TaC, 2.2 wt-% NbC, 2.9 wt-% (Ti,W)C 50/50 (H.C. Starck), 1.1 wt-% TiN and balance WC, with a binder phase alloyed with W corresponding to an S-value of 0.83 was produced by conventional milling of the raw material powders, pressing of green compacts and subsequent sintering at 1430°C. Investigation of the microstructure after sintering showed that the cemented carbide inserts had a cubic carbide free zone with a thickness of 22 µm. The cobalt concentration in the zone was 1.4 times that in the bulk of the substrate. The mean intercept length of the tungsten carbide phase was 1.2 µm.

Example 2

Cemented carbide cutting inserts from Example 1 were coated with a layer of MTCVD Ti(C,N) according to step 1 (below). The thickness of the MTCVD layer was about 6 µm. On to this layer the following alumina layers were deposited:

a) 5 µm $\alpha$-$Al_2O_3$ was deposited according to steps 2-6: (Invention).

*Step 1: MTCVD coating*

| | | |
|---|---|---|
| Gas mixture | $TiCl_4$ | = 4.0% |
| | $CH_3CN$ | = 1.0% |
| | $N_2$ | = 20% |
| | Balance: | $H_2$ |
| Duration | 150 min | |
| Temperature | 850 °C | |
| Pressure | 100 mbar | |

*Step 2: Bonding layer*

| | | |
|---|---|---|
| Gas mixture | $TiCl_4$ | = 2.8% |
| | $AlCl_3$ | = 0.8 - 4.2% |
| | CO | = 5.8% |
| | $CO_2$ | = 2.2 % |
| | $N_2$ | = 5-6% |
| | Balance: | $H_2$ |
| Duration | 60 min | |

(continued)

*Step 2: Bonding layer*

| | |
|---|---|
| Temperature | 1000 °C |
| Pressure | 100 mbar |

*Step 3: Aluminising step*

| | | |
|---|---|---|
| Gas mixture | $AlCl_3$ | = 0.8 -4.2% |
| | Balance: | $H_2$ |
| Duration | 15 min or 2 min pulsating | |
| Temperature | 1000 °C | |
| Pressure | 50 mbar | |

*Step 4: Oxidising step*

| | | |
|---|---|---|
| Gas mixture | $CO_2$ | = 0.1% |
| | Balance: | $H_2$+ 20% $N_2$ |
| Duration | 2 min or 20 s pulsating | |
| Temperature | 1000 °C | |
| Pressure | 100 mbar | |

*Step 5: Nucleation step*

| | | |
|---|---|---|
| Gas mixture | $AlCl_3$ | = 3,2 % |
| | HCL | = 2.0 % |
| | $CO_2$ | = 1.9 % |
| | Balance | $H_2$ |
| Duration | 60 min | |
| Temperature | 1000 °C | |
| Pressure | 210 mbar | |

*Step 6: Deposition*

| | | |
|---|---|---|
| Gas mixture | $AlCl_3$ | = 3.9 % |
| | HCL | = 1.5 % |
| | $CO_2$ | = 6.2% |
| | $H_2S$ | = 0.2% |
| | Balance: | $H_2$ |
| Duration | 300 min | |
| Temperature | 1000 °C | |
| Pressure | 50 mbar | |

b) 5 μm κ-$Al_2O_3$ was deposited according to the prior art, where the κ-$Al_2O_3$ layer was deposited without oxidisation resulting into a epitaxial growth of κ-$Al_2O_3$ on the Ti(C,N). (Prior art).
c) 5 μm α-$Al_2O_3$ was deposited according to prior art. The nucleation control did not in this case produce 100% pure α-$Al_2O_3$ but a mixture of κ-$Al_2O_3$ and α-$Al_2O_3$ instead. The κ-$Al_2O_3$ phase transformed during the deposition process to α-$Al_2O_3$ with a high dislocation density as a result.

(Prior art).

The total coating thickness of the experimental coatings was 11 μm in all cases.

Example 3

The inserts from Example 2a and 2c (alpha oxides) were studied by using XRD. Coating c exhibited a random texture but the coating a according to this invention showed a clear (012) texture. Table 1 shows the obtained texture coefficients for coating a.

Table 1.

| hkl | Invention (coating a) |
|---|---|
| 012 | 3.39 |
| 104 | 0.11 |
| 110 | 0.22 |
| 113 | 0.15 |
| 024 | 2.04 |
| 116 | 0.09 |

Example 4

Inserts according to the invention (coating a) from Example 2 were tested against inserts according to prior art, (coating c from Example 2), under the following conditions.

| | |
|---|---|
| Work piece | Cylindrical bar |
| Insert type | CNMG120408-M3 |
| Cutting speed | 220 m/min |
| Feed | 0.4 mm/rev |
| Depth of cut | 2.5 mm |
| Time in cut | 4.7 min |
| Remarks | Interrupted cut without coolant |

The cutting edges are shown in Fig. 2 after 4.7 min cutting. The inserts produced according to prior art showed severe edge chipping and crater wear while those according to the invention did not have any chipping. The wear on these inserts was very uniform and the inserts could have been used much longer.

This demonstrates that the $\alpha$-$Al_2O_3$ with a texture according to the invention has a much tougher and wear resistant behaviour than the $\alpha$-$Al_2O_3$ produced according to prior art.

Example 5

Inserts a) and b) from Example 2 were compared in metal cutting. Coating a is composed of defect free $\alpha$-$Al_2O_3$ according to the invention and coating b is composed of $\kappa$-$Al_2O_3$ according to prior art. The test conditions were the following:

| | |
|---|---|
| Work piece | Cylindrical slotted bar |
| Material | SS 1672-08 |
| Insert type | CNMG120408-M5 |
| Cutting speed | 80 m/min |
| Feed | 0.1, 0.125, 0.16, 0.20, 0.315, 0.4, 0.5, 0.63, 0.8, 1.0 mm/rev gradually increased after 10 mm length of cut |
| Depth of cut | 2.0 mm |
| Remarks | Interrupted machining mode test without coolant. |

(continued)

| | |
|---|---|
| Tool life criteria | Gradually increased feed until breakage. 10 edges of each variant were tested. |

The results are presented in Figure 3.

From the results in Fig. 3 it is obvious that the inserts according to the invention being composed of $\alpha$-$Al_2O_3$ with a texture exhibited a much better toughness than those of $\kappa$-$Al_2O_3$ produced according to prior art.

Example 6

The coatings a and b from Example 2 were tested under the following conditions.

| | |
|---|---|
| Work piece | Cylindrical bar |
| Material | SS 1672-08 |
| Insert type | CNMG120408-M5 |
| Cutting speed | 250 m/min |
| Feed | 0.4 mm/rev |
| Depth of cut | 2.0 mm |
| Time in cut | 3.6 min |
| Remarks | Interrupted machining mode test without coolant; three edges of each variant were tested. |

The prior art inserts coated with $\kappa$-$Al_2O_3$ had severe plastic deformation after 3.6 min cutting while those produced according to the invention exhibited very little plastic deformation. The superiority of $\alpha$-$Al_2O_3$ to prevent plastic deformation is clear.

Example 7

The following three variants were tested by interrupted turning of stainless steel.

a. Invention Example 2a
b. Strongly leading grade from Competitor 1 for interrupted turning of stainless steel.
c. Strongly leading grade from Competitor 2 for interrupted turning of stainless steel.

| | |
|---|---|
| Work piece | Cylindrical bar |
| Material | SS2343 |
| Insert type | CNMG120408-M3 |
| Cutting speed | 150 m/min |
| Feed | 0.4 mm/rev |
| Depth of cut | 2.0 mm |
| Time in cut | 7.6 min |
| Remarks | Interrupted machining mode test with coolant; three edges of each variant were tested. |

After 7.6 minutes, the flank wear of the three variants was measured:

| Variant | Flank wear (mm) |
|---|---|
| a. Invention | 0.20 |
| b. Competitor 1 | 0.29 |
| c. Competitor 2 | 0.26 |

The results show that the cemented carbide tool with a layer of $\alpha$-$Al_2O_3$ with a texture according to the invention exhibits enhanced tool life as compared with competitor products.

Example 8

The same variants that were tested in Examples 5 and 6 were also tested in continuous turning in ordinary carbon steel. The cutting data were:

| | |
|---|---|
| Work piece | Cylindrical bar |
| Material | SS 1672-08 |
| Insert type | CNMG120412-M3 |
| Cutting speed | 300 m/min |
| Feed | 0.4 mm/rev |
| Depth of cut | 2.0 mm |
| Remarks | Continuous cut with coolant |
| Tool life criterion | Flank wear >0.3 mm, three edges of each variant were tested. |

| Results | Tool life (min) |
|---|---|
| Invention | 9.0 |
| Prior Art | 6.0 |

The test results show that the cemented carbide according to the invention, i.e. with a coating layer of $\alpha$-$Al_2O_3$ with a texture, exhibits longer tool life than prior art material with $\kappa$-$Al_2O_3$ in continuous cutting.

Thus, the examples above show that the cemented carbide according to the invention is superior to prior art materials both regarding wear resistance and toughness.

## Claims

**1.** Cutting tool insert particularly useful for toughness demanding machining such as medium and rough turning of steels and also for turning of stainless steels consisting of a cemented carbide substrate and a coating **characterised in that** the cemented carbide substrate consists of

- WC, 8.5-9.5 wt-% Co and 6.5-9.5 wt-% carbides of Ti, Nb and Ta with a weight ratio Ta and Nb of 1.0-3.0 and Ti and Nb of 0.5-1.5
- a Co-binder highly alloyed with W and with an S-value of 0.79-0.89
- a tungsten carbide phase with a mean intercept length of 0.9-1.3 $\mu$m with a binder phase enriched and essentially cubic carbide free surface zone of a thickness of 20-40 $\mu$m and
- a coating comprising at least one 2-12 $\mu$m alumina layer composed of columnar $\alpha$-$Al_2O_3$ grains with texture coefficients:

a) TC(012)=2.5-3.5 and the related TC(024)> 0.6 x TC(012)
b) TC(104), TC(110), TC(113), TC(116) all <0.3

whereby the texture coefficient TC(hkl) is defined as

$$TC(hkl) = \frac{I(hkl)}{I_0(hkl)} \left\{ \frac{1}{n} \sum \frac{I(hkl)}{J_0(hkl)} \right\}^{-1}$$

where

I(hkl) = measured intensity of the (hkl) reflection
Io(hkl) = standard intensity according to JCPDS card no 46-1212 n = number of reflections used in the calculation
(hkl) reflections used are; (012), (104), (110), (113), (024), (116) whereby the coating comprises a first layer

adjacent the cemented carbide substrate of CVD Ti(C,N), CVD TiN, CVD TiC, MTCVD Ti(C,N), MTCVD Zr(C,N), MTCVD Ti(B,C,N), CVD HfN or combinations thereof preferably of MTCVD Ti(C,N) having a thickness of from 1 to 10 μm, preferably from 3 to 8 μm, most preferably about 6 μm.

2. Cutting insert according to the previous claim **characterised in** said columnar α-$Al_2O_3$ grains have a width of 0.5-3 μm with a length/width ratio from 2 to 10, preferably 4 to 8.

3. Cutting insert according to any the previous claims **characterised in** a total coating thickness of 7-15 μm, preferably 8-13 μm.

**Patentansprüche**

1. Schneidwerkzeugeinsatz, der insbesondere für Zähigkeit erfordernde Bearbeitung von Nutzen ist, wie die mittelfeine und die grobe Drehbearbeitung von Stählen und auch zum Drehen von rostfreien Stählen, bestehend aus einem Hartmetallsubstrat und einer Beschichtung, **dadurch gekennzeichnet, daß** das Hartmetallsubstrat aus folgendem besteht:

   - WC, 8,5-9,5 Gew.-% Co und 6,5-9,5 Gew.-% Carbide von Ti, Nb und Ta mit einem Gewichtsverhältnis von Ta und Nb von 1,0-3,0 und von Ti und Nb von 0,5-1,5
   - einem Co-Binder, der mit W hoch legiert ist und einen S-Wert von 0,79-0,89 hat,
   - einer Wolframcarbidphase mit einer mittleren Abschnittslänge von 0,9-1,3 μm mit einer mit Binderphase angereicherten und im wesentlichen von kubischem Carbid freien Oberflächenzone mit einer Dicke von 20-40 μm und
   - einer Beschichtung, die wenigstens eine 2-12 μm dicke Aluminiumoxidlage umfaßt, die aus kolumnaren α-$Al_2O_3$-Körnern mit den folgenden Texturkoeffizienten besteht:

     a) TC(012) = 2,5-3,5 und dem damit in Beziehung stehenden TC(024) > 0,6 x TC(012)
     b) TC(104), TC(110), TC(113), TC(116) alle < 0,3,

   wobei der Texturkoeffizient TC(hkl) definiert ist als

$$TC(hkl) = \frac{I(hkl)}{I_0(hkl)} \left\{ \frac{1}{n} \sum \frac{I(hkl)}{I_0(hkl)} \right\}^{-1}$$

   worin

     I(hkl) = gemessene Intensität der (hkl)-Reflexion
     $I_0$(hkl) = Standardintensität gemäß JCPDS-Karte Nr. 46-1212
     n = Anzahl der in der Berechnung verwendeten Reflexionen;
     die verwendeten (hkl)-Reflexionen sind (012), (104), (110), (113), (024), (116), wobei die Beschichtung eine erste Lage aus CVD-Ti(C,N), CVD-TiN, CVD-TiC, MTCVD-Ti(C,N), MTCVD-Zr(C,N), MTCVD-Ti(B, C,N), CVD-HfN oder Kombinationen davon, bevorzugt aus MTCVD-Ti(C,N), mit einer Dicke von 1 bis 10 μm, bevorzugt von 3 bis 8 μm, am meisten bevorzugt von etwa 6 μm, neben dem Hartmetallsubstrat umfaßt.

2. Schneideinsatz nach dem vorangegangenen Anspruch, **dadurch gekennzeichnet, daß** die kolumnaren α-$Al_2O_3$-Körner eine Breite von 0,5-3 μm mit einem Länge/Breite-Verhältnis von 2 zu 10, bevorzugt von 4 zu 8, haben.

3. Schneideinsatz nach einem der vorangegangenen Ansprüche, **dadurch gekennzeichnet, daß** die Beschichtungsgesamtdicke 7-15 μm, bevorzugt 8-13 μm, beträgt.

**Revendications**

1. Insert pour outil de coupe, particulièrement utile pour un usinage demandant un dégrossissage, tel qu'un tournage

finition moyenne et de dégrossissage d'aciers, et également pour le tournage d'aciers inoxydables, consistant en un substrat en carbure cémenté et d'un revêtement, **caractérisé en ce que** le substrat en carbure cémenté est composé de :

- WC, 8,5 à 9,5 % en poids de Co et de 6,5 à 9,5 % en poids de carbures de Ti, Nb et Ta, avec un rapport de poids entre Ta et Nb de 1,0 et 3,0 et entre Ti et Nb de 0,5 et 1,5,
- un liant au Co fortement allié au W et ayant une valeur S dans la fourchette de 0,79 et 0,89,
- une phase de carbure de tungstène ayant une longueur moyenne d'interception de 0,9 à 1,3 μm, avec une phase de liant enrichie et une zone de surface pratiquement exempte de carbure cubique, d'une épaisseur de 20 et 40 μm, et
- un revêtement, comprenant au moins une couche d'alumine de 2 à 12 μm d'épaisseur, composé de grains colonnaires d'$\alpha$-$Al_2O_3$, ayant des coefficients de texture :

  a) TC(012) = 2,5 à 3,5, et le TC(024) afférent > 0,6 x TC(012).
  b) TC(104), TC(110), TC(113), TC(116) tous <0,3,

le coefficient de texture TC(hkl) étant défini comme :

$$TC(hkl) = \frac{I(hkl)}{I_0(hkl)} \left\{ \frac{1}{n} \sum \frac{I(hkl)}{I_0(hkl)} \right\}^{-1}$$

où

I(hkl) = intensité mesurée de la réflexion (hkl)
$I_0$(hkl) = intensité standard selon document JCPDS n° 46-1212
n = nombre de réflexions utilisées dans le calcul
les réflexions (hkl) utilisées sont : (012), (104), (110), (113), (024), (116), de manière que le revêtement comprenne une première couche, adjacente au substrat en carbure cémenté, de CVD Ti(C,N), CVD TiN, CVD TiC, MTCVD Ti(C,N), MTCVD Zr(C,N), MTCVD Ti(B,C,N), CVD HfN, ou des combinaisons de ceux-ci, de préférence de MTCVD Ti(C,N), ayant une épaisseur dans la fourchette de 1 à 10 μm, de préférence de 3 à 8 μm, de manière la mieux préférée d'environ 6 μm.

**2.** Insert pour outil de coupe selon la revendication précédente, **caractérisé en ce que** lesdits grains colonnaires d'$\alpha$-$Al_2O_3$ ont une largeur de 0,5 à 3 μm, avec rapport longueur/largeur de 2 à 10, de préférence de 4 à 8.

**3.** Insert pour outil de coupe selon l'une quelconque des revendications précédentes, **caractérisé par** une épaisseur totale de revêtement de 7 à 15 μm, de préférence de 8 à 13 μm.

Figure 1.

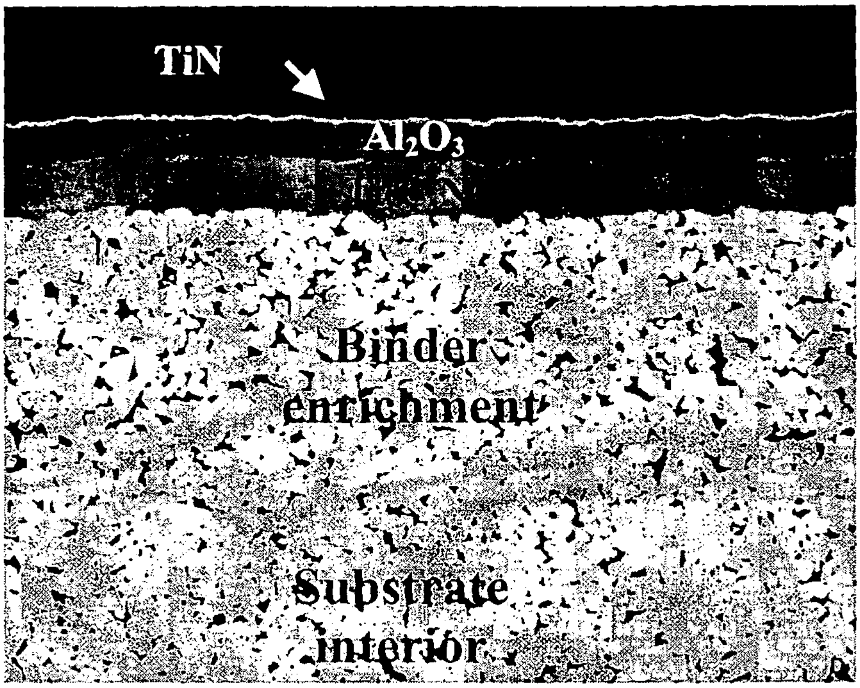

Figure 2.

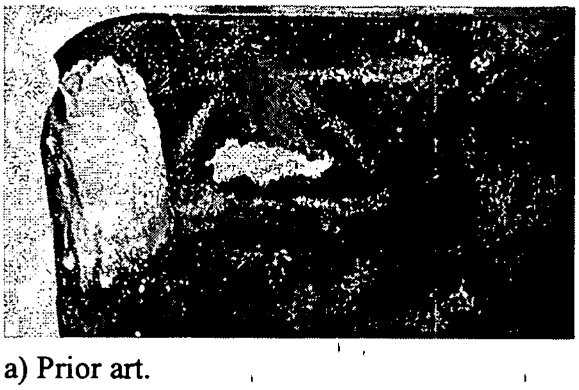

a) Prior art.

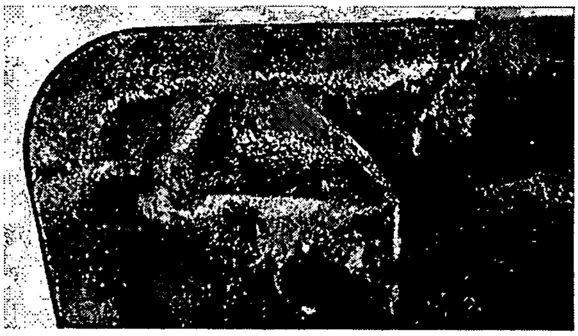

b) According to this invention.

Figure 3.

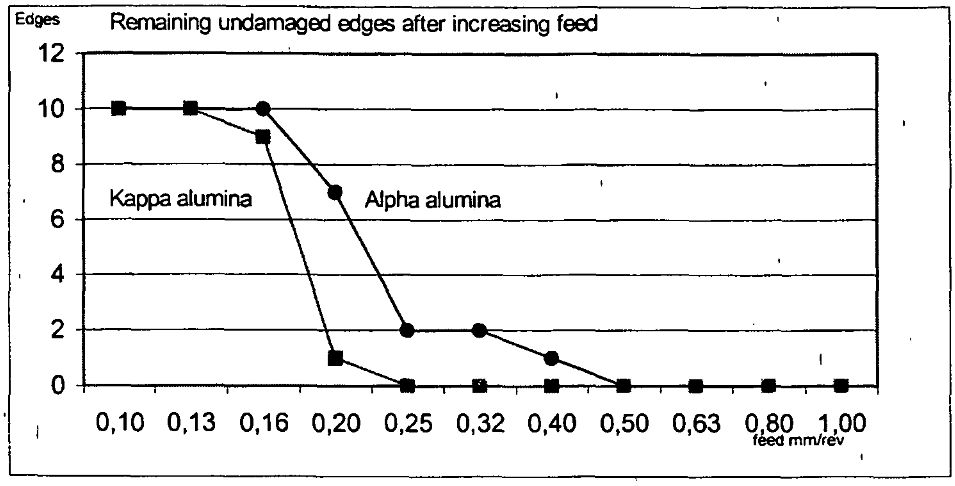
Edges
Remaining undamaged edges after increasing feed
12
10
8
6
4
2
0
Kappa alumina
Alpha alumina
0,10 0,13 0,16 0,20 0,25 0,32 0,40 0,50 0,63 0,80 1,00
feed mm/rev

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4277283 A
- US 4610931 A
- US 4548786 A
- EP 1026271 A
- EP 1348779 A
- US 7163735 B
- EP 1288335 A
- EP 630744 A
- US 5654035 A
- US 5137774 A